# EUROPEAN PATENT APPLICATION

(11) **EP 4 831 664 A1**
(43) Date of publication of application: **28.10.2026**
(21) Application number: 24910058.7
(22) Date of filing: 23.09.2024
(51) Int. Cl.: G01R 31/388, G01R 31/367, G01R 31/382

(54) **BATTERY CAPACITY DETERMINATION METHOD, BATTERY CAPACITY DETERMINATION APPARATUS, AND ELECTRIC DEVICE**

(30) Priority: 25.12.2023 CN 202311817011
(71) Applicant: BYD Company Limited, Shenzhen, Guangdong 518118 (CN)
(72) Inventor: FENG, Tianyu, Shenzhen, Guangdong 518118 (CN); DENG, Linwang, Shenzhen, Guangdong 518118 (CN); LI, Xiaoqian, Shenzhen, Guangdong 518118 (CN); CAO, Huili, Shenzhen, Guangdong 518118 (CN)
(74) Representative: Taor, Simon Edward William
(86) International application number: PCT/CN2024/120489
(87) International publication number: WO 2025/139114

(57) **Abstract**

A battery capacity determining method and apparatus, and an electric device are provided. The method includes: determining one or more battery capacity calculation methods for a current capacity determining period based on a current and a voltage of a battery, determining a first capacity quality factor corresponding to each method, and determining a first battery capacity based on a second capacity quality factor and the first capacity quality factor.

## Description

### CROSS-REFERENCE TO RELATED APPLICATIONS

The present disclosure claims priority to Chinese Patent Application No. 202311817011.4, filed with the China National Intellectual Property Administration on December 25, 2023 and entitled "BATTERY CAPACITY DETERMINING METHOD AND APPARATUS, AND ELECTRIC DEVICE", which is incorporated herein by reference in its entirety.

### TECHNICAL FIELD

The present disclosure relates to the field of battery technologies, and in particular, to a battery capacity determining method and apparatus, and an electric device.

### BACKGROUND

An electric vehicle and a renewable energy system rely on a battery for working. A battery state of health (state of health, SOH) is used to predict a life and a performance degradation status of a battery, is determined based on a battery capacity and a factory capacity of the battery, and is critical for management of a battery management system (battery management system, BMS). Accurate monitoring of the battery state of health helps optimize system running and detect a potential problem in advance.

### SUMMARY

Embodiments of the present disclosure provide a battery capacity determining method and apparatus, and an electric device. A battery capacity calculation method to be used is pre-determined based on collected data, accuracy corresponding to each method is determined, accuracy of a battery capacity in a current round is compared with accuracy of a previously updated battery capacity, and data is updated based on a battery capacity with higher accuracy. Therefore, a more accurate battery capacity can be determined, and a battery state of health is more accurately reflected.

According to a first aspect, the present disclosure provides a battery capacity determining method. The method includes the following steps: determining one or more battery capacity calculation methods for a current capacity determining period based on a collected current and voltage of a battery; determining a first capacity quality factor corresponding to each battery capacity calculation method, to obtain one or more first capacity quality factors, where the first capacity quality factor is used to indicate accuracy of a battery capacity obtained through calculation by using the battery capacity calculation method; and determining a first battery capacity of the battery based on a second capacity quality factor and the one or more first capacity quality factors, where the second capacity quality factor is determined based on a first capacity quality factor obtained in a previous capacity determining period and an inter-period cycle factor, and the inter-period cycle factor is used to represent a cycling status of the battery between the previous capacity determining period and the current capacity determining period.

In the foregoing process, one or more battery capacity calculation methods to be triggered and the first capacity quality factor, that is, calculation accuracy, corresponding to each battery capacity calculation method are pre-determined based on data such as the current and the voltage of the battery. The first capacity quality factor is compared with the second capacity quality factor obtained in the previous capacity determining period to determine a higher capacity quality factor, and a battery capacity obtained through calculation by using a battery capacity calculation method corresponding to the higher capacity quality factor is more accurate. Compared with a current manner in which a battery capacity can be determined only in a same manner in any condition, the battery capacity determining method provided in the present disclosure can ensure accuracy of a battery capacity in this embodiment. A result with low accuracy does not need to be considered, so that the battery capacity can be more conveniently and accurately determined. Moreover, a battery state of health is determined based on the battery capacity and a factory capacity of the battery, the battery state of health can be further more accurately reflected.

In a possible implementation, a specific process of determining a first battery capacity of the battery based on the one or more first capacity quality factors and a second capacity quality factor is as follows: when the second capacity quality factor is greater than the one or more first capacity quality factors, determining that the first battery capacity is maintained as a second battery capacity, where the second battery capacity is a battery capacity determined in the previous capacity determining period; or when there is a first capacity quality factor greater than the second capacity quality factor, determining that the first battery capacity is a battery capacity obtained through calculation by using a battery capacity calculation method corresponding to a maximum first capacity quality factor in the one or more first capacity quality factors. In the foregoing process, a maximum capacity quality factor is determined by comparing the currently record second capacity quality factor updated in the previous capacity determining period with the one or more first capacity quality factors obtained through calculation, and a battery capacity corresponding to the maximum capacity quality factor is used as a final battery capacity. Compared with a current manner in which a battery capacity can be determined only in a same manner regardless of a situation, in the present disclosure, the present disclosure avoids occurrence of a case in which a result with relatively poor accuracy overwrites a previous result with relatively high accuracy, so that the battery capacity can be more accurately determined, thereby more accurately reflecting a battery state of health.

In a possible implementation, the inter-period cycle factor is determined by a time interval and a capacity throughput between the previous capacity determining period and the current capacity determining period. For example, each time the time interval between the previous capacity determining period and the current capacity determining period reaches one time threshold, or when the capacity throughput between the previous capacity determining period and the current capacity determining period reaches one capacity throughput threshold, the capacity quality factor determined in the previous capacity determining period decreases by a first percentage, and the second capacity quality factor is updated. The time threshold may be five days or another proper value, the capacity throughput threshold is a nominal capacity, for example, 2000 milliampere-hour, and the first percentage may be a proper value such as 1%. This is not specifically limited in the present disclosure. In the foregoing method, a relatively accurate second capacity quality factor may be determined for comparison with the first capacity quality factor, to further determine an accurate battery capacity.

In a possible implementation, the determining, based on a collected current and voltage of a battery, one or more battery capacity calculation methods and a first capacity quality factor corresponding to each battery capacity calculation method specifically includes the following steps: determining, based on the collected current and voltage of the battery, an initial battery state of charge (state of charge, SOC) for charging; determining the one or more battery capacity calculation methods based on the battery state of charge at the beginning of charging, where the battery capacity calculation method includes an ampere-hour integration method, an inflection point positioning method, or a life calendar method; and determining, based on the collected current and voltage of the battery and the battery capacity calculation method, the first capacity quality factor corresponding to each battery capacity calculation method.

In a possible implementation, the determining the one or more battery capacity calculation methods based on the battery state of charge at the beginning of charging specifically includes the following steps: when the battery state of charge at the beginning of charging is less than a first threshold, determining that the battery capacity calculation method includes one or more of the ampere-hour integration method, the inflection point positioning method, or the life calendar method; when the battery state of charge at the beginning of charging is greater than or equal to the first threshold and is less than a second threshold, determining that the battery capacity calculation method includes one or more of the inflection point positioning method or the life calendar method; or when the ampere-hour integration method and the inflection point positioning method are not triggered, determining that the battery capacity calculation method is the life calendar method.

An SOC may be first determined based on the collected current and voltage, and one or more battery capacity calculation methods to be triggered are determined based on the SOC. For example, when the SOC at a start charging point is less than 30%, one or more of the ampere-hour integration method, the inflection point positioning method, or the life calendar method may be triggered. When the SOC at the start charging point is greater than or equal to 30% and is less than 60%, one or more of the inflection point positioning method or the life calendar method may be triggered. The life calendar method can be triggered in any case. Specifically, the life calendar method is usually triggered in a case in which the ampere-hour integration method and the inflection point positioning method are not triggered for a long time. After the battery capacity calculation method to be triggered is determined, the first capacity quality factor corresponding to each battery capacity calculation method is determined. Because a capacity quality factor may determine accuracy of a battery capacity calculation method, a battery capacity obtained through calculation by using a most accurate battery capacity calculation method may be determined in a subsequent process. No other inaccurate battery capacity needs to be considered, so that the battery capacity can be more conveniently and accurately determined.

In a possible implementation, a specific process of determining the one or more battery capacity calculation methods based on the battery state of charge at the beginning of charging is as follows: when the battery state of charge at the beginning of charging is less than a first threshold, and the battery is in a fully charged state at the end of charging, determining that the battery capacity calculation method includes one or more of the ampere-hour integration method, the inflection point positioning method, or the life calendar method, where the fully charged state is a case in which the battery is charged to a fully charged threshold; when the battery state of charge at the beginning of charging is greater than or equal to the first threshold and is less than a second threshold, and the battery is in the fully charged state at the end of charging, determining that the battery capacity calculation method includes one or more of the inflection point positioning method or the life calendar method; when the ampere-hour integration method and the inflection point positioning method are not triggered, and the battery is in the fully charged state at the end of charging, determining that the battery capacity calculation method is the life calendar method; or when the battery is in a non-fully charged state at the end of charging, determining that the battery capacity calculation method is the life calendar method. The fully charged state in the foregoing process is not limited to a case in which the battery is charged to 100%, and it is feasible when the battery is charged to the fully charged threshold. The fully charged threshold may be 95%, 98%, or the like. The fully charged threshold may alternatively be another proper value. This is not specifically limited in the present disclosure.

In a possible implementation, the determining, based on the collected current and voltage of the battery and the one or more battery capacity calculation methods, the first capacity quality factor corresponding to each battery capacity calculation method specifically includes the following steps: when the battery capacity calculation method is the ampere-hour integration method, determining, based on the collected voltage of the battery, a slope corresponding to the voltage, and determining the first capacity quality factor with reference to rest time, where the rest time is time during which the battery is in an open-circuit state.

In the ampere-hour integration method, a battery capacity is determined based on a ratio of a charged capacity of the battery to a change value of an SOC. Because the charged capacity of the battery and the SOC at the fully charged state are not affected by another factor, accuracy of this calculation method mainly depends on accuracy of the SOC at a start charging point. The SOC at the start charging point is determined based on the voltage. Specifically, accuracy of the SOC at the start charging point is related to a location of the voltage and the rest time. When the slope corresponding to the voltage is relatively high, that is, when the voltage is in a slope segment in an SOC-open circuit voltage relationship diagram, the SOC has relatively high identifiability. When the slope corresponding to the voltage is relatively low, that is, when the voltage is in a flat segment in the SOC-open circuit voltage relationship diagram, the SOC has relatively low identifiability. Therefore, the first capacity quality factor determined when the voltage is in the slope segment is higher. The voltage rebounds after discharging, and longer rest time indicates a more stable voltage and a more accurate SOC. Therefore, the determined first capacity quality factor is higher with extension of the rest time. In the foregoing method, various factors that affect a capacity quality factor are quantified, and calculation accuracy of each of different capacity calculation methods may be determined, thereby more accurately determining the battery capacity.

In a possible implementation, the determining, based on the collected current and voltage of the battery and the one or more battery capacity calculation methods, the first capacity quality factor corresponding to each battery capacity calculation method specifically includes the following content: when the battery capacity calculation method is the inflection point positioning method, determining a battery state of health based on the collected current and voltage and a collected temperature of the battery, and determining the first capacity quality factor based on the battery state of health. In the inflection point positioning method, a battery capacity is determined based on a capacity from an inflection point to the fully charged state. Because a charged capacity of the battery is not affected by another factor, accuracy of this calculation method mainly depends on accuracy of an inflection point location. A change of the inflection point location is only related to a battery aging degree. As the battery ages, the inflection point location is offset and accuracy is reduced. The battery state of health is a ratio of the battery capacity to a factory capacity of the battery, and may reflect an aging status of the battery. Therefore, the first capacity quality factor corresponding to the inflection point positioning method may be determined based on the battery state of health obtained through calculation. The first capacity quality factor decreases as the battery state of health decreases. The first capacity quality factor corresponding to the inflection point positioning method may be relatively accurately determined based on the specific value of the battery state of health, to be used for accuracy comparison with another battery capacity calculation method in a subsequent process.

In a possible implementation, the determining the first capacity quality factor based on the collected current and voltage of the battery and the battery capacity calculation method specifically includes the following content: when the battery capacity calculation method is the life calendar method, determining that the first capacity quality factor is 50%. In the life calendar method, data such as the collected current and voltage, and a capacity throughput are input to an empirical model to determine a battery state of health and a battery capacity. The capacity throughput refers to a sum of absolute values of all charging amounts and absolute values of all discharging amounts since the battery started to work. Accuracy of the life calendar method is related to experimental data of the empirical model and an actual use status of the battery, and accuracy is relatively low and difficult to evaluate. Therefore, when the method is triggered, the corresponding first capacity quality factor may be set to 50%, or another value close to 50%, or another possible proper value. This is not specifically limited in the present disclosure.

In a possible implementation, the battery capacity determining method further includes: maintaining the second capacity quality factor unchanged when the second capacity quality factor is greater than the one or more first capacity quality factors; or when there is a first capacity quality factor greater than the second capacity quality factor, replacing the second capacity quality factor with the maximum first capacity quality factor in the one or more first capacity quality factors. A capacity quality factor with highest accuracy is recorded, and may be compared with a newly generated capacity quality factor when a battery capacity is determined next time, to determine a most accurate battery capacity corresponding to a maximum capacity quality factor. A battery capacity calculation method with highest accuracy may be determined based on the capacity quality factor, and the battery capacity can be accurately updated in place without a need to simultaneously consider a plurality of battery capacity calculation methods.

According to a second aspect, the present disclosure provides a method for updating a state of healthy of a battery capacity. The method includes: determining one or more battery capacity calculation methods for a current capacity determining period based on a current and a voltage of a battery; determining a first capacity quality factor corresponding to each battery capacity calculation method, to obtain one or more first capacity quality factors, where the first capacity quality factor is used to indicate accuracy of a battery capacity obtained through calculation by using the battery capacity calculation method; and determining a first battery capacity of the battery based on a second capacity quality factor and the one or more first capacity quality factors, and determining a first battery state of health based on the first battery capacity and a factory capacity of the battery, where the second capacity quality factor is determined based on a first capacity quality factor obtained in a previous capacity determining period and an inter-period cycle factor, and the inter-period cycle factor is used to represent a cycling status of the battery between the previous capacity determining period and the current capacity determining period, and the first battery state of health is used to indicate a life and performance of the battery.

According to a third aspect, the present disclosure provides a battery capacity determining apparatus. The apparatus includes an obtaining module and a processing module. The obtaining module is configured to obtain a collected current and voltage of a battery. The processing module is configured to determine one or more battery capacity calculation methods for a current capacity determining period based on the collected current and voltage of the battery. The processing module is further configured to determine a first capacity quality factor corresponding to each battery capacity calculation method, to obtain one or more first capacity quality factors, where the first capacity quality factor is used to indicate accuracy of a battery capacity obtained through calculation by using the battery capacity calculation method. The processing module is further configured to determine a first battery capacity of the battery based on a second capacity quality factor and the one or more first capacity quality factors, where the second capacity quality factor is determined based on a first capacity quality factor obtained in a previous capacity determining period and an inter-period cycle factor, and the inter-period cycle factor is used to represent a cycling status of the battery between the previous capacity determining period and the current capacity determining period.

In a possible implementation, the processing module is specifically configured to: when the second capacity quality factor is greater than the one or more first capacity quality factors, determine that the first battery capacity is maintained as a second battery capacity; or when there is a first capacity quality factor greater than the second capacity quality factor, determine that the first battery capacity is a battery capacity obtained through calculation by using a battery capacity calculation method corresponding to a maximum first capacity quality factor in the one or more first capacity quality factors.

In a possible implementation, the inter-period cycle factor used to determine the second capacity quality factor in the foregoing process is determined by a time interval and a capacity throughput between the previous capacity determining period and the current capacity determining period. Each time the time interval between the previous capacity determining period and the current capacity determining period reaches one time threshold, or each time the capacity throughput between the previous capacity determining period and the current capacity determining period reaches one capacity throughput threshold, the capacity quality factor determined in the previous capacity determining period decreases by a first percentage, and the second capacity quality factor is updated.

In a possible implementation, the processing module is specifically configured to: determine, based on the collected current and voltage of the battery, an initial battery state of charge (state of charge, SOC) for charging; determine the one or more battery capacity calculation methods based on the battery state of charge at the beginning of charging, where the battery capacity calculation method includes an ampere-hour integration method, an inflection point positioning method, or a life calendar method; and determine, based on the collected current and voltage of the battery and the battery capacity calculation methods, the first capacity quality factor corresponding to each battery capacity calculation method.

In a possible implementation, the processing module is specifically configured to: when the battery state of charge at the beginning of charging is less than a first threshold, determine that the battery capacity calculation method includes one or more of the ampere-hour integration method, the inflection point positioning method, or the life calendar method; when the battery state of charge at the beginning of charging is greater than or equal to the first threshold and is less than a second threshold, determine that the battery capacity calculation method includes one or more of the inflection point positioning method or the life calendar method; or when the ampere-hour integration method and the inflection point positioning method are not triggered, determine that the battery capacity calculation method is the life calendar method.

In a possible implementation, the processing module is specifically configured to: when the battery state of charge at the beginning of charging is less than a first threshold, and the battery is in a fully charged state at the end of charging, determine that the battery capacity calculation method includes one or more of the ampere-hour integration method, the inflection point positioning method, or the life calendar method, where the fully charged state is a case in which the battery is charged to a fully charged threshold; when the battery state of charge at the beginning of charging is greater than or equal to the first threshold and is less than a second threshold, and the battery is in the fully charged state at the end of charging, determine that the battery capacity calculation method includes one or more of the inflection point positioning method or the life calendar method; when the ampere-hour integration method and the inflection point positioning method are not triggered, and the battery is in the fully charged state at the end of charging, determine that the battery capacity calculation method is the life calendar method; or when the battery is in a non-fully charged state at the end of charging, determine that the battery capacity calculation method is the life calendar method.

In a possible implementation, the processing module is specifically configured to: when the battery capacity calculation method is the ampere-hour integration method, determine the first capacity quality factor based on the voltage collected from the battery and rest time, where the rest time is time during which the battery is in an open-circuit state.

In a possible implementation, the processing module is specifically configured to: when the battery capacity calculation method is the inflection point positioning method, determine a battery state of health based on the collected current and voltage and a collected temperature of the battery, and determine the first capacity quality factor based on the battery state of health.

In a possible implementation, the processing module is specifically configured to: when the battery capacity calculation method is the life calendar method, determine that the first capacity quality factor is 50%.

In a possible implementation, the processing module is further configured to: maintain the second capacity quality factor unchanged when the second capacity quality factor is greater than the one or more first capacity quality factors; or when there is a first capacity quality factor greater than the second capacity quality factor, replace the second capacity quality factor with the maximum first capacity quality factor in the one or more first capacity quality factors.

According to a fourth aspect, the present disclosure provides an electronic apparatus. The electronic apparatus includes a processor and a memory. The memory stores a computer program, and the processor executes the computer program, to enable the electronic apparatus to perform the method according to the first aspect or the second aspect.

According to a fifth aspect, the present disclosure provides an electric device. The electric device is configured to perform the method according to the first aspect, and includes the battery capacity determining apparatus according to the third aspect or the electronic apparatus according to the fourth aspect. The electric device may be a vehicle, an aircraft, a ship, an air conditioner, an energy storage cabinet, or the like.

According to a sixth aspect, the present disclosure provides a computer program product including instructions. When the instructions are run by an electronic apparatus, the electronic apparatus is enabled to perform the method according to the first aspect or the second aspect.

According to a seventh aspect, the present disclosure provides a computer-readable storage medium. The computer-readable storage medium stores a program, and when the program runs on an electronic apparatus, the electronic apparatus is enabled to perform the method according to the first aspect or the second aspect.

Based on the implementations provided in the foregoing aspects, the present disclosure may further provide more implementations through further combinations.

### BRIEF DESCRIPTION OF DRAWINGS

To describe technical solutions in the embodiments of the present disclosure more clearly, the following briefly describes the accompanying drawings required for describing the embodiments.
FIG. 1 is a schematic diagram of a structure of a battery capacity determining system according to an embodiment of the present disclosure;
FIG. 2 is a flowchart of a battery capacity determining method according to an embodiment of the present disclosure;
FIG. 3 is a schematic diagram of a voltage characteristic curve during battery charging according to an embodiment of the present disclosure;
FIG. 4 is a schematic diagram of a structure of a battery capacity determining apparatus according to an embodiment of the present disclosure;
FIG. 5 is a schematic diagram of a structure of an electronic apparatus according to an embodiment of the present disclosure; and
FIG. 6 is a schematic diagram of a structure of an electric device according to an embodiment of the present disclosure.

### DESCRIPTION OF EMBODIMENTS

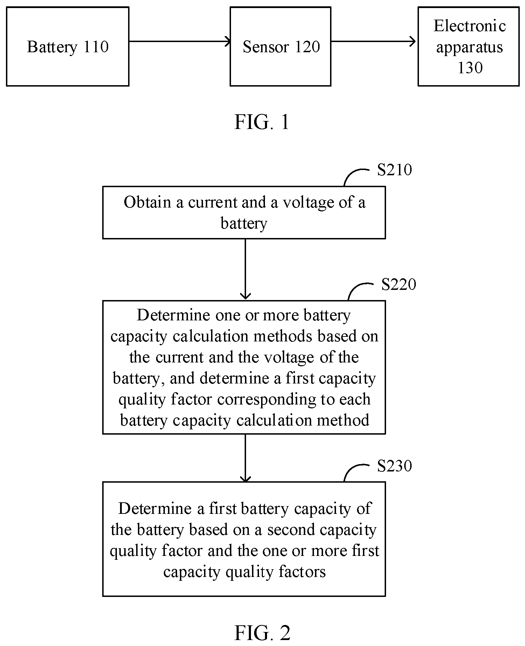

As shown in FIG. 1, FIG. 1 is a schematic diagram of a structure of a battery capacity determining system according to an embodiment of the present disclosure. The system includes a battery 110, a sensor 120, and an electronic apparatus 130.

In specific implementation, the sensor includes a current sensor, a voltage sensor, a temperature sensor, and the like. The current sensor is configured to measure and collect a charging and discharging current of a battery, the voltage sensor is configured to monitor and collect a voltage of the battery, and the temperature sensor is configured to monitor and collect a temperature of the battery. The foregoing plurality of sensors send data separately collected by the sensors to the electronic apparatus, so that the electronic apparatus determines a battery capacity, a battery state of charge (state of charge, SOC), a battery state of health (state of health, SOH), and the like based on the collected data, to manage the battery. In a possible implementation, the system may include more types and quantities of sensors. This is not specifically limited in the present disclosure.

In specific implementation, the electronic apparatus may be a battery management controller (battery management controller, BMC), a micro control unit (micro control unit, MCU), or the like, and is configured to receive and process data collected by the current sensor, the voltage sensor, the temperature sensor, and the like, to monitor and manage various parameters of the battery. In a possible implementation, the electronic apparatus obtains the battery capacity through calculation by using an ampere-hour integration method based on data separately collected by sensors such as the current sensor and the voltage sensor. The ampere-hour integration method is a battery capacity calculation method in which when a battery state of charge at the beginning of charging is known, the battery is charged to a fully charged state, and the battery capacity is determined based on a charged capacity and a change amount of an SOC, where the SOC is determined based on the obtained data collected by the current sensor and the voltage sensor, and may represent a remaining charge of the battery. Alternatively, the electronic apparatus determines the battery capacity by using an inflection point positioning method based on the data separately collected by the current sensor, the voltage sensor, and the temperature sensor. In the inflection point positioning method, an inflection point location is determined by using a voltage characteristic curve corresponding to a case when the battery is charged by using a low current, and the battery capacity is determined based on a capacity corresponding to the inflection point position and a capacity obtained when the battery is charged to a fully charged state. Alternatively, the electronic apparatus determines a current battery state of health based on the data separately collected by the current sensor, the voltage sensor, and the temperature sensor, and a predetermined life calendar model, to determine the battery capacity. The electronic apparatus may simultaneously calculate the battery capacity based on one or more of the foregoing methods, and perform battery management based on the battery capacity obtained through calculation.

In a possible implementation, the battery capacity determining system may further include more types and quantities of battery management system components. This is not specifically limited in the present disclosure.

Currently, an electric vehicle develops rapidly, and driving of the electric vehicle relies on normal working of a battery. To ensure normal working of the battery, a battery state of health needs to be monitored in real time. The battery state of health is used to predict a life and a performance degradation status of the battery, and plays an important role in management of a vehicle battery management system. Because a battery capacity is an important parameter for evaluating the battery state of health, the battery state of health is usually determined by using a method for determining the battery capacity. The electronic apparatus determines, based on one or more of an ampere-hour integration method, an inflection point positioning method, or a life calendar method, battery capacities respectively corresponding to the methods. As the battery ages, accuracy of an inflection point location gradually decreases, and when the battery ages severely, accuracy of a battery capacity determined by using the inflection point positioning method is far less than that of the ampere-hour integration method. The life calendar method is related to model training data and an actual use status of the battery, and can only reflect an average aging status of the battery, resulting in relatively low accuracy. Therefore, all the foregoing battery capacity calculation methods have an accuracy issue.

Therefore, embodiments of the present disclosure provide a battery capacity determining method. A battery capacity calculation method to be triggered and accuracy corresponding to each method are pre-determined based on collected data, accuracy obtained through calculation is compared with accuracy of a battery capacity updated previously, to select a calculation method with higher accuracy to update the battery capacity, so that accuracy of determining the battery capacity can be improved, thereby more accurately determining a battery state of health. In addition, an accurate reference may also be provided for a battery state of charge, to prevent a vehicle from breaking down or the like. A specific process of the foregoing battery capacity determining method provided in the present disclosure is as follows.

As shown in FIG. 2, FIG. 2 is a flowchart of a battery capacity determining method according to an embodiment of the present disclosure. The method is applied to the system shown in FIG. 1, and the method includes the following plurality of steps.

Step S210: Obtain a current and a voltage of a battery.

Current data and voltage data respectively collected from the battery by the current sensor and the voltage sensor are obtained. The current and the voltage are used to determine data such as a battery capacity, an SOC, and an SOH. In a possible implementation, temperature data of the battery collected by the temperature sensor and more quantities and types of battery-related data collected by another sensor may be further obtained. This is not specifically limited in the present disclosure. In a possible implementation, data such as the current and the voltage of the battery may alternatively be obtained from a database. This is not specifically limited in the present disclosure.

Step S220: Determine one or more battery capacity calculation methods based on the current and the voltage of the battery, and determine a first capacity quality factor corresponding to each battery capacity calculation method.

After the current and the voltage of the battery are obtained, first, a battery state of charge is determined based on the current and the voltage, and one or more battery capacity calculation methods to be used in a current capacity determining period are determined based on the battery state of charge. The battery capacity calculation method includes an ampere-hour integration method, an inflection point positioning method, or a life calendar method. Then, the first capacity quality factor corresponding to each battery capacity calculation method is calculated based on different data such as the current, the voltage, and rest time.

In a possible implementation, after a battery state of charge at the beginning of charging is obtained through calculation, a capacity calculation method that may be triggered is determined based on a value of the battery state of charge at the beginning of charging: when the battery state of charge at the beginning of charging is less than a first threshold, and the battery is in a fully charged state at the end of charging, determining that the battery capacity calculation method includes one or more of the ampere-hour integration method, the inflection point positioning method, or the life calendar method; when the battery state of charge at the beginning of charging is greater than or equal to the first threshold and is less than a second threshold, and the battery is in the fully charged state at the end of charging, determining that the battery capacity calculation method includes one or more of the inflection point positioning method or the life calendar method; or when the ampere-hour integration method and the inflection point positioning method are not triggered for a long time, and the battery is in the fully charged state at the end of charging, or when the battery is in a non-fully charged state at the end of charging, determining that the battery capacity calculation method is the life calendar method. In a possible implementation, in the foregoing process, the fully charged state of the battery is not limited to a case of charging to 100%, and it is feasible when the battery is charged to a fully charged threshold. The fully charged threshold may be a proper value such as 95% or 98%. This is not specifically limited in the present disclosure.

In a specific implementation, the foregoing first threshold may be 30%, the foregoing second threshold may be 60%, and the first threshold and the second threshold may alternatively be other possible values. This is not specifically limited in the present disclosure.

After the one or more battery capacity calculation methods to be triggered in the current capacity determining period are determined, the first capacity quality factor corresponding to each battery capacity calculation method is determined with reference to different battery data.

In a possible implementation, a triggered battery capacity calculation method is the ampere-hour integration method. In the ampere-hour integration method, a battery capacity is determined based on a ratio of a charged capacity of the battery to a change value of an SOC. Because the charged capacity of the battery and the SOC at the fully charged state are not affected by another factor, accuracy of this calculation method mainly depends on accuracy of the SOC at a start charging point. The SOC at the start charging point is determined based on the voltage. Specifically, accuracy of the SOC at the start charging point is related to a location of the voltage and rest time. Therefore, in this embodiment of the present disclosure, a slope corresponding to the collected voltage is determined based on the voltage, to determine the location of the voltage, and the first capacity quality factor is determined with reference to the rest time, where the rest time is time during which the battery is in an open-circuit state.

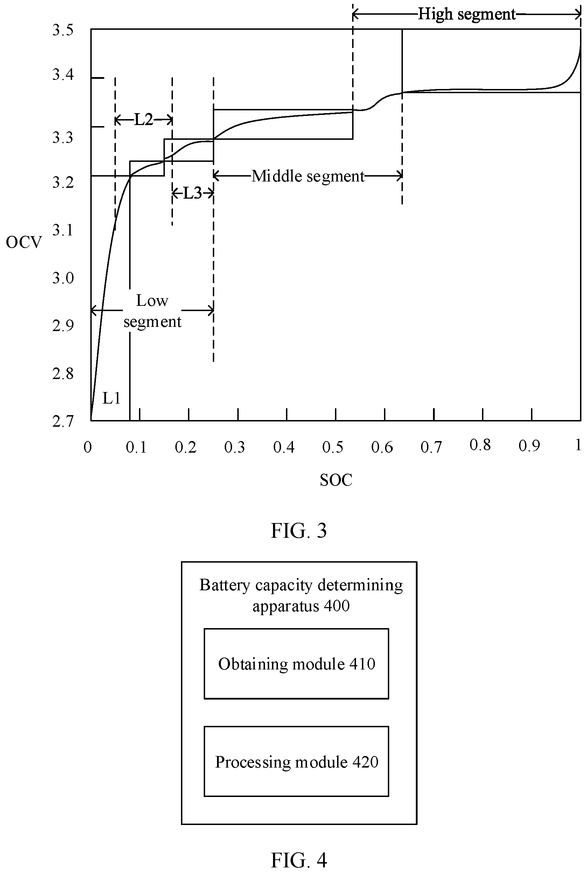

As shown in FIG. 3, FIG. 3 is a schematic diagram of a voltage characteristic curve during battery charging according to an embodiment of the present disclosure. A horizontal coordinate of the voltage characteristic curve is an SOC, and a vertical coordinate is an open circuit voltage (Open Circuit Voltage, OCV). The voltage characteristic curve is divided into three segments of flat segments: a low segment, a middle segment, and a high segment. The low segment includes slope segments corresponding to L1 and L3, and a flat segment corresponding to L2. In FIG. 3, only a voltage characteristic curve corresponding to a lithium iron phosphate battery with a temperature of 20°C is illustrated for description. Actually, voltage characteristic curves respectively corresponding to more temperature conditions may be further included. This is not specifically limited in the present disclosure.

In a possible implementation, after the collected voltage and the slope corresponding to the voltage are obtained, the location of the voltage can be determined. When the slope is relatively high, it may be determined that the start charging point is located in the slope segments corresponding to L1 and L3. In this case, the SOC at the start charging point has relatively high identifiability. When the slope is relatively low, it may be determined that the start charging point is located in the flat segment. In this case, the SOC at the start charging point has relatively low identifiability. Therefore, it may be determined that in a case of same rest time, the first capacity quality factor corresponding to the ampere-hour integration method is higher when the voltage is located in the slope segment. The voltage rebounds after discharging, and longer rest time indicates a more stable voltage and a more accurate SOC. Therefore, it may be determined that longer rest time indicates a higher determined first capacity quality factor.

In a specific implementation, when the voltage is in the slope segment and the rest time is greater than 2 hours, a quality factor of the SOC at the start charging point is 100%, and the quality factor may be used as the first capacity quality factor of the ampere-hour integration method in this case. When the voltage is in the flat segment and the rest time is 2 hours, a quality factor of the SOC at the start charging point is 70%, and the quality factor may be used as the first capacity quality factor of the ampere-hour integration method in this case. As the rest time increases, the first capacity quality factor linearly increases. When the rest time reaches 8 hours, the first capacity quality factor increases to 100%. In the foregoing method, various factors that affect a capacity quality factor are quantified, and accuracy of the ampere-hour integration method in different cases may be determined. In a subsequent process, comparison is made with a historically recorded capacity quality factor and the first capacity quality factor of another battery capacity calculation method, to determine a most accurate battery capacity.

In another possible implementation, a triggered battery capacity calculation method is the inflection point positioning method. In the inflection point positioning method, a battery capacity is determined based on a capacity from an inflection point to the fully charged state. Because a charged capacity of the battery is not affected by another factor, accuracy of this calculation method mainly depends on accuracy of an inflection point location. An inflection point appears in a slope segment between the flat segment in the middle segment and the flat segment in the high segment in FIG. 3. A change of the inflection point location is only related to a battery aging degree. As the battery ages, the inflection point location is offset and accuracy is reduced. A battery state of health is a ratio of the battery capacity to a factory capacity of the battery, and may reflect an aging status of the battery. Therefore, the first capacity quality factor corresponding to the inflection point positioning method may be determined based on the battery state of health obtained through calculation. The first capacity quality factor decreases as the battery state of health decreases. For example, for a new battery with an SOH of 100%, the first capacity quality factor corresponding to the inflection point positioning method is 90%. As the battery ages, the SOH of the battery decreases to 70%, and the first capacity quality factor corresponding to the inflection point positioning method decreases to 60%. The first capacity quality factor corresponding to the inflection point positioning method may be relatively accurately determined based on the specific value of the battery state of health. The capacity quality factor is used for accuracy comparison with another battery capacity calculation method in a subsequent process, to finally determine an accurate battery capacity.

In another possible implementation, a triggered battery capacity calculation method is the life calendar method. In the life calendar method, data such as the collected current and voltage, and a capacity throughput are input to an empirical model to determine a battery state of health and a battery capacity. The capacity throughput refers to a sum of absolute values of all charging amounts and absolute values of all discharging amounts since the battery started to work. In a possible implementation, the life calendar method may alternatively determine the battery state of health and the battery capacity based on more types of data, such as mileage. This is not specifically limited in the present disclosure. Accuracy of the life calendar method is related to experimental data of the empirical model and an actual use status of the battery, and accuracy is relatively low and difficult to evaluate. Therefore, when the method is triggered, the corresponding first capacity quality factor is set to 50%. Certainly, the first capacity quality factor corresponding to the life calendar method may alternatively be a value close to 50%, or another proper value. This is not specifically limited in the present disclosure. In this embodiment of the present disclosure, the first capacity quality factor corresponding to the life calendar method that is difficult to evaluate is determined, so that accuracy of the life calendar method is compared with accuracy of another battery capacity calculation method.

In the foregoing process, a triggered battery capacity calculation method is pre-determined based on data such as the collected current and voltage, and a capacity quality factor corresponding to each battery capacity calculation method is obtained by quantifying each factor that affects the capacity quality factor. Calculation accuracy of each battery capacity calculation method may be determined based on the capacity quality factor to determine accuracy of battery capacities obtained through calculation by using different calculation methods, to select a battery capacity calculated by using a most accurate calculation method, so that a most accurate battery capacity closest to a true value can be directly determined.

Step S230: Determine a first battery capacity of the battery based on a second capacity quality factor and the one or more first capacity quality factors.

After the one or more first capacity quality factors are determined, the first capacity quality factor is compared with the second capacity quality factor. The second capacity quality factor is determined based on a first capacity quality factor obtained in a previous capacity determining period and an inter-period cycle factor, and the inter-period cycle factor is used to represent a cycling status of the battery between the previous capacity determining period and the current capacity determining period.

In a possible implementation, the inter-period cycle factor is determined by a time interval and a capacity throughput between the previous capacity determining period and the current capacity determining period. Each time the time interval between the previous capacity determining period and the current capacity determining period reaches one time threshold, or each time the capacity throughput between the previous capacity determining period and the current capacity determining period reaches one capacity throughput threshold, the first capacity quality factor obtained in the previous capacity determining period decreases by a first percentage, and the second capacity quality factor is updated. In a possible implementation, the time threshold may be five days or another proper value, the capacity throughput threshold is a nominal capacity, for example, 2000 milliampere-hour, and the first percentage may be a proper value such as 1%. This is not specifically limited in the present disclosure.

In a specific implementation, the first capacity quality factor obtained in the previous capacity determining period is 70%, the time interval between the previous capacity determining period and the current capacity determining period is 30 days, which reaches six time thresholds, and the capacity throughput reaches six capacity throughput thresholds. When the first percentage is 1%, the capacity quality factor decreases by 12%, and an updated second capacity quality factor is 58%. In the foregoing method, a relatively accurate second capacity quality factor may be determined for comparison with the first capacity quality factor, to further determine an accurate battery capacity.

In a possible implementation, when the second capacity quality factor is greater than all the first capacity quality factors, it is determined that a battery capacity recorded in the previous period has relatively high accuracy, and it is determined that the first battery capacity is maintained as a second battery capacity corresponding to the second capacity quality factor. Alternatively, when there is a first capacity quality factor greater than the second capacity quality factor, it is determined that the battery capacity obtained through calculation by using the battery capacity calculation method in the current round has higher accuracy, and the battery capacity recorded in the previous period is updated. An updated first battery capacity is a battery capacity obtained through calculation by using a battery capacity calculation method corresponding to a maximum first capacity quality factor in the one or more first capacity quality factors.

In this embodiment of the present disclosure, in a process of updating a battery capacity, accuracy of different battery capacity calculation methods is considered, and the second capacity quality factor updated previously is compared with first capacity quality factors corresponding to different battery capacity calculation methods in the current round, which can avoid occurrence of a case that a newly generated inaccurate battery capacity overwrites a last more accurate battery capacity, and avoid reducing accuracy of the battery capacity, thereby updating data with a battery capacity with highest accuracy.

In a possible implementation, after the first battery capacity of the battery is determined, a first battery state of health is determined based on the first battery capacity and a factory capacity of the battery, to update a battery state of health. The battery state of health is an important indicator for measuring an overall health degree of the battery, and is of great significance to a driving range, a battery life, vehicle performance management, and the like. Therefore, after the first battery capacity is determined, the battery state of health may be further updated to obtain a current accurate battery state of health, to provide an accurate basis for optimizing battery performance and prolonging battery performance.

In a possible implementation, a capacity quality factor may be further updated based on a result of comparison between the first capacity quality factor and the historically recorded second capacity quality factor. When the second capacity quality factor is greater than the one or more first capacity quality factors, the second capacity quality factor is maintained unchanged; or when there is a first capacity quality factor greater than the second capacity quality factor, the second capacity quality factor is replaced with the maximum first capacity quality factor in the one or more first capacity quality factors. A capacity quality factor with highest accuracy is recorded, and may be compared with a newly generated capacity quality factor when a battery capacity is determined next time, to determine a most accurate battery capacity corresponding to a maximum capacity quality factor. In addition, a battery capacity calculation method with highest accuracy may be determined based on the capacity quality factor, and the battery capacity can be directly updated accurately.

In a specific implementation, when a current capacity quality factor is 70%, the battery cycles for three complete periods in thirty days, that is, an accumulated capacity is six nominal capacities, and it may be determined that the capacity quality factor decreases by 12%, decreasing from 70% to 58%.

In this case, it is determined, based on the collected voltage, to trigger the ampere-hour integration method in the case that the rest time is 2 hours and the start charging point is the SOC in the flat segment, to determine that the first capacity quality factor corresponding to the ampere-hour integration method in this case is 70%, which is greater than the current capacity quality factor 58%. In this case, the battery capacity may be updated. An updated battery capacity is obtained through calculation by using the ampere-hour integration method. If a battery pack is a new battery pack with an SOH=100% in this case, it is determined to trigger the inflection point positioning method, and it is determined that the first capacity quality factor corresponding to the inflection point positioning method in this case is 90%, which is greater than the previous first capacity quality factor 70% corresponding to the ampere-hour integration method. In this case, the battery capacity is updated again, to use a battery capacity determined based on the inflection point positioning method to overwrite the foregoing battery capacity obtained through calculation by using the ampere-hour integration method.

Then, the ampere-hour integration method in the case that the rest time is 8 hours and the SOC at the start charging point is located in the slope segment is triggered, and it is determined that the first capacity quality factor corresponding to the ampere-hour integration method in this case is 100%, which is greater than the previous first capacity quality factor 90% corresponding to the inflection point positioning method. In this case, a battery capacity determined based on the ampere-hour integration method in the current round is used to overwrite the previous battery capacity obtained through calculation by using the inflection point positioning method.

In conclusion, according to the battery capacity determining method provided in this embodiment of the present disclosure, a battery capacity calculation method to be triggered is pre-determined and a capacity quality factor corresponding to each calculation method is determined, accuracy of a capacity quality factor obtained through calculation and accuracy of a capacity quality factor updated previously are determined, to select a battery capacity corresponding to a larger capacity quality factor to update data. In the present disclosure, accuracy of each battery capacity calculation method in different start cases may be obtained by quantifying a factor that affects a capacity quality factor, so that a most accurate battery capacity calculation method can be determined. Therefore, in the present disclosure, a more accurate battery capacity can be directly determined, and more accurate battery capacity may further determine a more accurate battery state of health, and may provide a more accurate reference for a battery state of charge, to prevent a vehicle from breaking down and the like.

As shown in FIG. 4, FIG. 4 is a schematic diagram of a structure of a battery capacity determining apparatus according to the present disclosure. The apparatus may be applied to the electronic apparatus shown in FIG. 1. The battery capacity determining apparatus 400 includes an obtaining module 410 and a processing module 420. The obtaining module is configured to obtain a collected current and voltage of a battery. The processing module is configured to determine one or more battery capacity calculation methods for a current capacity determining period based on the collected current and voltage of the battery. The processing module is further configured to determine a first capacity quality factor corresponding to each battery capacity calculation method, to obtain one or more first capacity quality factors, where the first capacity quality factor is used to indicate accuracy of a battery capacity obtained through calculation by using the battery capacity calculation method. The processing module is further configured to determine a first battery capacity of the battery based on a second capacity quality factor and the one or more first capacity quality factors, where the second capacity quality factor is determined based on a first capacity quality factor obtained in a previous capacity determining period and an inter-period cycle factor, and the inter-period cycle factor is used to represent a cycling status of the battery between the previous capacity determining period and the current capacity determining period. The obtaining module may be a sampling assembly, and is configured to collect the current and the voltage of the battery. The processing module may be a component such as an MCU.

In specific implementation, the obtaining module is configured to perform step S210 shown in FIG. 2, and the processing module is configured to perform steps S220 and S230 shown in FIG. 2. In a possible implementation, the obtaining module and the processing module may alternatively perform more steps. This is not specifically limited in the present disclosure.

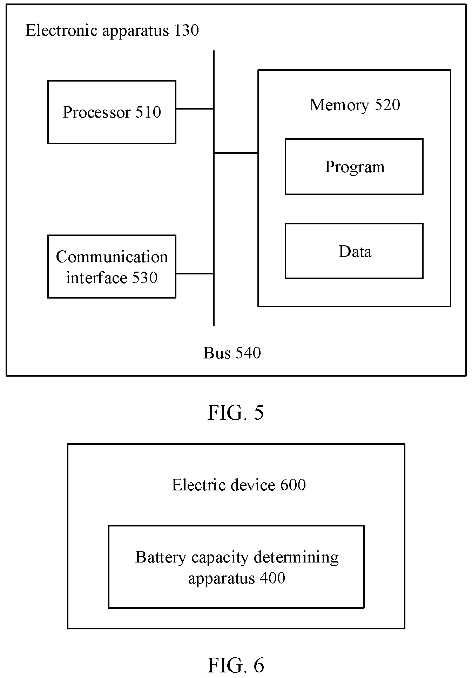

As shown in FIG. 5, FIG. 5 is a schematic diagram of a structure of an electronic apparatus according to the present disclosure. The electronic apparatus 130 includes a processor 510, a memory 520, a communication interface 530, and a bus 540. The processor, the memory, and the communication interface may be connected to each other through an internal bus, or may communicate with each other through wireless transmission or another means.

The processor 510 may include at least one general-purpose processor, such as a central processing unit (central processing unit, CPU) or a combination of a CPU and a hardware chip. The processor 510 is configured to execute various types of digital storage instructions. The processor may execute a corresponding instruction to implement any step shown in FIG. 2.

The memory 520 may be a volatile memory, such as a random access memory, a dynamic random access memory, a static random access memory, or a synchronous dynamic random access memory. The memory may further include a combination of the foregoing types. The memory 520 may include a program and data. The processor 510 may execute program code to perform the steps shown in FIG. 2. The memory may further store data such as a battery capacity and a capacity quality factor. This is not specifically limited in the present disclosure.

The communication interface 530 may be configured to receive a current, a voltage, a temperature, or the like of a battery collected by a sensor. This is not specifically limited in the present disclosure.

It should be noted that, FIG. 5 is merely a possible implementation of this embodiment of the present disclosure. In actual application, the electronic apparatus may further include more or less components. This is not limited herein.

As shown in FIG. 6, FIG. 6 is a schematic diagram of a structure of an electric device according to an embodiment of the present disclosure. In specific implementation, the electric device 600 may be a vehicle, an aircraft, a ship, an air conditioner, an energy storage cabinet, or the like. This is not specifically limited in the present disclosure.

In a possible implementation, the electric device may include the battery capacity determining apparatus 400, and perform all steps shown in FIG. 2. A specific structure of the battery capacity determining apparatus is shown in FIG. 4, and details are not described herein again. In a possible implementation, the electric device may include more or fewer components. This is not specifically limited in the present disclosure.

An embodiment of the present disclosure further provides a computer-readable storage medium. The computer-readable storage medium stores instructions, and when the instructions are run on a processor, the method procedure shown in FIG. 2 is implemented.

An embodiment of the present disclosure further provides a computer program product. When the computer program product runs on a processor, the method procedure shown in FIG. 2 is implemented.

The foregoing descriptions are merely specific implementations of the present disclosure, but the protection scope of the present disclosure is not limited thereto. Various equivalent modifications or replacements readily figured out by any technician who is familiar with this technical field within the technical scope disclosed in the present disclosure shall fall within the protection scope of the present disclosure. Therefore, the protection scope of the present disclosure shall be subject to the protection scope of the claims.

## Claims

1. A battery capacity determining method, comprising:
determining one or more battery capacity calculation methods for a current capacity determining period based on a collected current and voltage of a battery;
determining a first capacity quality factor corresponding to each battery capacity calculation method, to obtain one or more first capacity quality factors, the first capacity quality factor being used to indicate accuracy of a battery capacity obtained through calculation by using the battery capacity calculation method; and
determining a first battery capacity of the battery based on a second capacity quality factor and the one or more first capacity quality factors, the second capacity quality factor being determined based on a first capacity quality factor obtained in a previous capacity determining period and an inter-period cycle factor, and the inter-period cycle factor being used to represent a cycling status of the battery between the previous capacity determining period and the current capacity determining period.

2. The method according to claim 1, wherein the determining a first battery capacity of the battery based on the one or more first capacity quality factors and a second capacity quality factor comprises:
when the second capacity quality factor is greater than the one or more first capacity quality factors, determining that the first battery capacity is maintained as a second battery capacity, the second battery capacity being a battery capacity determined in the previous capacity determining period; or
when there is a first capacity quality factor greater than the second capacity quality factor, determining that the first battery capacity is a battery capacity obtained through calculation by using a battery capacity calculation method corresponding to a maximum first capacity quality factor in the one or more first capacity quality factors.

3. The method according to claim 1 or 2, wherein the inter-period cycle factor is determined by a time interval and a capacity throughput between the previous capacity determining period and the current capacity determining period.

4. The method according to any one of claims 1 to 3, wherein the determining, based on a current and a voltage of a battery, one or more battery capacity calculation methods and a first capacity quality factor corresponding to each battery capacity calculation method comprises:
determining, based on the collected current and voltage of the battery, a battery state of charge at the beginning of charging;
determining the one or more battery capacity calculation methods based on the battery state of charge at the beginning of charging, the battery capacity calculation method comprising an ampere-hour integration method, an inflection point positioning method, or a life calendar method; and
determining, based on the collected current and voltage of the battery and the one or more battery capacity calculation methods, the first capacity quality factor corresponding to each battery capacity calculation method.

5. The method according to claim 4, wherein the determining the one or more battery capacity calculation methods based on the battery state of charge at the beginning of charging comprises:
when the battery state of charge at the beginning of charging is less than a first threshold, determining that the battery capacity calculation method comprises one or more of the ampere-hour integration method, the inflection point positioning method, or the life calendar method;
when the battery state of charge at the beginning of charging is greater than or equal to the first threshold and is less than a second threshold, determining that the battery capacity calculation method comprises one or more of the inflection point positioning method or the life calendar method; or
when the ampere-hour integration method and the inflection point positioning method are not triggered, determining that the battery capacity calculation method is the life calendar method.

6. The method according to claim 4, wherein the determining the one or more battery capacity calculation methods based on the battery state of charge at the beginning of charging comprises:
when the battery state of charge at the beginning of charging is less than a first threshold, and the battery is in a fully charged state at the end of charging, determining that the battery capacity calculation method comprises one or more of the ampere-hour integration method, the inflection point positioning method, or the life calendar method, the fully charged state being a case in which the battery is charged to a fully charged threshold;
when the battery state of charge at the beginning of charging is greater than or equal to the first threshold and is less than a second threshold, and the battery is in the fully charged state at the end of charging, determining that the battery capacity calculation method comprises one or more of the inflection point positioning method or the life calendar method;
when the ampere-hour integration method and the inflection point positioning method are not triggered, and the battery is in the fully charged state at the end of charging, determining that the battery capacity calculation method is the life calendar method; or
when the battery is in a non-fully charged state at the end of charging, determining that the battery capacity calculation method is the life calendar method.

7. The method according to any one of claims 1 to 6, wherein the determining, based on the collected current and voltage of the battery and the one or more battery capacity calculation methods, the first capacity quality factor corresponding to each battery capacity calculation method comprises:
when the battery capacity calculation method is the ampere-hour integration method, determining the first capacity quality factor based on the collected voltage of the battery and rest time, the rest time being time during which the battery is in an open-circuit state.

8. The method according to any one of claims 1 to 6, wherein the determining, based on the collected current and voltage of the battery and the one or more battery capacity calculation methods, the first capacity quality factor corresponding to each battery capacity calculation method comprises:
when the battery capacity calculation method is the inflection point positioning method, determining the first capacity quality factor based on the collected current and voltage and a collected temperature of the battery.

9. The method according to any one of claims 1 to 6, wherein the determining, based on the collected current and voltage of the battery and the one or more battery capacity calculation methods, the first capacity quality factor corresponding to each battery capacity calculation method comprises:
when the battery capacity calculation method is the life calendar method, determining that the first capacity quality factor is 50%.

10. The method according to any one of claims 1 to 9, further comprising:
maintaining the second capacity quality factor unchanged when the second capacity quality factor is greater than the one or more first capacity quality factors; or
when there is a first capacity quality factor greater than the second capacity quality factor, replacing the second capacity quality factor with the maximum first capacity quality factor in the one or more first capacity quality factors.

11. A method for updating a state of health of a battery capacity, comprising:
determining a first battery state of health based on a first battery capacity and a factory capacity of a battery, the first battery state of health being used to indicate a life and performance of the battery, and the first battery capacity being used to be determined based on the method according to any one of claims 1 to 10.

12. A battery capacity determining apparatus, comprising:
an obtaining module, configured to obtain a collected current and voltage of a battery; and
a processing module, configured to perform the method according to any one of claims 1 to 10 based on the collected current and voltage of the battery.

13. An electronic apparatus, comprising a processor and a memory, the memory storing a computer program, and the processor executing the computer program, to enable the electronic apparatus to perform the method according to any one of claims 1 to 11.

14. An electric device, comprising the battery capacity determining apparatus according to claim 12 or the electronic apparatus according to claim 13.

15. A computer program product comprising instructions, the instructions being run by an electronic apparatus, to enable the electronic apparatus to perform the method according to any one of claims 1 to 11.

16. A computer-readable storage medium, storing a program, the program running on an electronic apparatus, to enable the electronic apparatus to perform the method according to any one of claims 1 to 11.
